(19) Europäisches Patentamt / European Patent Office / Office européen des brevets

(11) **EP 3 547 481 B1**

(12) **EUROPÄISCHE PATENTSCHRIFT**

(45) Veröffentlichungstag und Bekanntmachung des Hinweises auf die Patenterteilung:
**13.01.2021 Patentblatt 2021/02**

(51) Int Cl.:
*H02J 3/04* (2006.01)    *H02J 13/00* (2006.01)

(21) Anmeldenummer: **18164941.9**

(22) Anmeldetag: **29.03.2018**

(54) **VERFAHREN ZUM ÜBERWACHEN EINES ELEKTRISCHEN NETZES**

METHOD FOR MONITORING AN ELECTRICAL GRID

PROCÉDÉ DE SURVEILLANCE D'UN RÉSEAU ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**02.10.2019 Patentblatt 2019/40**

(73) Patentinhaber: **Siemens Aktiengesellschaft**
**80333 München (DE)**

(72) Erfinder:
• **Litzinger, Andreas**
 **90765 Fürth (DE)**
• **Piel, Stefan**
 **45359 Essen (DE)**

(56) Entgegenhaltungen:
**EP-A1- 2 806 280**

• **OHNO T ET AL: "Islanding protection system based on synchronized phasor measurements and its operational experiences", POWER AND ENERGY SOCIETY GENERAL MEETING - CONVERSION AND DELIVERY OF ELECTRICAL ENERGY IN THE 21ST CENTURY, 2008 IEEE, IEEE, PISCATAWAY, NJ, USA, 20. Juli 2008 (2008-07-20), Seiten 1-5, XP031304404, ISBN: 978-1-4244-1905-0**

**Beschreibung**

Die Erfindung bezieht sich auf ein Verfahren zum Überwachen eines elektrischen Energieversorgungsnetzes oder eines Teilnetzes des Energieversorgungsnetzes, insbesondere eines zuvor anhand eines anderen Verfahrens ermittelten Teilnetzes des Energieversorgungsnetzes, wobei an zumindest zwei Messstellen des Energieversorgungsnetzes oder Teilnetzes erfasste Messwerte ausgewertet werden.

Ein derartiges Verfahren ist aus der US-Patentschrift US 9,804,209 B2 bekannt. Bei dem vorbekannten Verfahren werden Frequenzwerte und Frequenzänderungswerte an verschiedenen Messstellen innerhalb eines Energieversorgungsnetzes erfasst und ausgewertet, um eine Asynchronität innerhalb des Energieversorgungsnetzes und eine Bildung von Teilnetzen bzw. Inseln, die für sich jeweils in einem vorgegebenen Maße synchron sind, zu erkennen. Das Dokument EP 2 806 280 A1 schlägt vor, zur Erkennung einer Inselbildung Messwerte (z.B. Phasenwinkel) mehrerer Messeinrichtungen zu vergleichen. Dabei ist das Netz bereits vorab in Subnetze unterteilt und es werden die Messwerte von Messeinrichtungen in diesen Subnetzen miteinander verglichen, um zu erkennen, ob zwischen den vorab definierten Subnetzen Winkelunterschiede vorliegen, die auf eine Inselbildung hinweisen. Das Dokument T. Ohno et al. "Islanding protection system based on synchronized phasor measurements and its operational experiences" offenbart, dass zur Inselerkennung die Phasenwinkel von einzelnen Sammelschienen jeweils mit einer Hauptsammelschiene verglichen werden und bei größeren Abweichungen eine Inselbildung erkannt wird.

Der Erfindung liegt die Aufgabe zugrunde, ein Verfahren zum Überwachen eines Netzes anzugeben, das besonders einfach zuverlässige Ergebnisse mit Blick auf eine Inselbildung liefert.

Diese Aufgabe wird erfindungsgemäß durch ein Verfahren mit den Merkmalen gemäß Patentanspruch 1 sowie durch eine Überwachungseinrichtung gemäß den Merkmalen des Anspruchs 13 gelöst. Vorteilhafte Ausgestaltungen des erfindungsgemäßen Verfahrens sind in Unteransprüchen angegeben.

Danach ist erfindungsgemäß vorgesehen, dass als Messwerte Phasenlagenwerte ausgewertet oder mit den Messwerten ermittelte Phasenlagenwerte ausgewertet werden, anhand der Phasenlagenwerte geprüft wird, ob das Energieversorgungsnetz oder das Teilnetz synchron arbeitet, und im Falle einer anhand der Phasenlagenwerte erkannten Asynchronität ein Inselerkennungssignal erzeugt wird.

Ein wesentlicher Vorteil des erfindungsgemäßen Verfahrens ist darin zu sehen, dass allein anhand von Phasenlagenwerten und damit sehr schnell eine zuverlässige Aussage über eine etwaige Asynchronität innerhalb eines Netzes oder Teilnetzes und eine etwaige Inselbildung getroffen werden kann. Auch kann in vorteilhafter Weise eine Inselbildung bei sehr geringen Frequenzabweichungen erkannt werden, die bei dem eingangs beschriebenen Verfahren auf der Basis von Frequenzwerten und Frequenzänderungswerten unter Umständen nicht immer erkannt wird.

Als Messwerte werden vorzugsweise Phasenlagenwerte von Messzeigern, insbesondere Spannungszeigern, ausgewertet.

Besonders bevorzugt werden als Messwerte Phasenlagenwerte von Leiterspannungszeigern oder Mitsystemspannungszeigern ausgewertet.

Im Falle einer anhand der Phasenlagenwerte erkannten Asynchronität werden vorzugsweise synchron arbeitende Inseln innerhalb des Energieversorgungsnetzes oder des jeweiligen Teilnetzes ermittelt.

Erfindungsgemäß ist außerdem vorgesehen, dass die Phasenlagenwerte unter Bildung einer sortierten Phasenlagenreihenfolge sortiert werden, ausgehend von dem größten oder kleinsten Phasenlagenwert - nachfolgend Startphasenwert genannt - der sortierten Phasenlagenreihenfolge die Differenz zu dem in der Phasenlagenreihenfolge nachfolgenden, also dem zweitgrößten oder zweitkleinsten, Phasenlagenwert ermittelt wird, das Inselerkennungssignal erzeugt wird, wenn die Phasenlagendifferenz zwischen dem Startphasenwert und dem nachfolgenden Phasenlagenwert betragsmäßig einen vorgegebenen Alarmschwellenwert überschreitet, und der Startphasenwert und der benachbarte Phasenlagenwert als synchron angesehen werden, wenn die Phasenlagendifferenz zwischen dem Startphasenwert und dem benachbarten Phasenlagenwert betragsmäßig den vorgegebenen Alarmschwellenwert unterschreitet.

Es kann in vorteilhafter Weise vorgesehen sein, dass die Phasenlagenwerte unter Bildung einer sortierten Phasenlagenreihenfolge sortiert werden und gemäß der sortierten Phasenlagenreihenfolge für jeden auf den Startphasenwert folgenden Phasenlagenwert jeweils ein Differenzbildungsschritt und ein Vergleichsschritt durchgeführt wird.

Bei der letztgenannten Ausführungsvariante ist es besonders vorteilhaft, wenn in dem Differenzbildungsschritt die Phasenlagendifferenz zwischen einem Referenzphasenwert, bei dem es sich um den Startphasenwert handelt, sofern er nicht in einem vorherigen Vergleichsschritt durch einen anderen Referenzphasenwert ersetzt worden ist, und dem jeweils folgenden Phasenlagenwert ermittelt wird.

Bezüglich des Vergleichsschritts ist es besonders vorteilhaft, wenn in dem Vergleichsschritt die Phasenlagendifferenz mit dem Alarmschwellenwert verglichen wird, die bei dem Vergleich betrachteten Phasenlagenwerte als synchron angesehen werden und mit dem Differenzbildungsschritt für den nachfolgenden Phasenlagenwert in der Phasenlagenreihenfolge und demselben Referenzphasenwert fortgefahren wird, wenn die Phasenlagendifferenz betragsmäßig den Alarmschwellenwert unterschreitet, und der bei dem vorherigen Differenzbildungsschritt als folgender Phasenlagenwert herangezogene Phasenlagenwert einer neuen Insel zugeordnet und als neuer Referenzphasenwert festgelegt wird und mit dem Differenzbildungsschritt für den nachfolgenden Phasenlagenwert in der Phasenlagenreihenfolge und dem neu festgesetzten Referenzphasenwert fortgefahren wird, wenn die Phasenlagendifferenz betragsmäßig den Alarmschwellenwert überschreitet.

Das Sortieren der Phasenlagenwerte umfasst bei einer ersten besonders vorteilhaften Verfahrensvariante vorzugsweise folgende Sortierschritte:

- Vorsortieren der Phasenlagenwerte nach Größe unter Bildung einer vorsortierten Phasenlagenreihenfolge,
- Prüfen, ob die Zeigerwinkeldifferenz zwischen dem Zeigerwinkel des Messzeigers, der zu dem größten Phasenlagenwert gehört, und dem Zeigerwinkel des Messzeigers, der zu dem kleinsten Phasenlagenwert gehört, den Alarmschwellenwert über- oder unterschreitet,
- im Falle einer Unterschreitung des Alarmschwellenwerts die Phasenlagenreihenfolge umsortiert wird, indem der kleinste Phasenlagenwert um 360° erhöht wird, und
- im Falle einer Überschreitung des Alarmschwellenwerts die Phasenlagenreihenfolge unverändert bleibt und die vorsortierte Phasenlagenreihenfolge als sortierte Phasenlagenreihenfolge weiterverwendet wird.

Bei der letztgenannten Verfahrensvariante ist es vorteilhaft, wenn nachfolgend in weiteren Umsortierschritten jeweils geprüft wird, ob die Differenz zwischen dem - gemäß Fortschritt des Umsortierens - jeweils aktuell kleinsten Phasenlagenwert und dem vor dem letzten Umsortierschritt kleinsten Phasenlagenwert den Alarmschwellenwert überschreitet, im Falle einer Unterschreitung des Alarmschwellenwerts die umsortierte Phasenlagenreihenfolge nochmals umsortiert wird, indem der aktuell kleinste Phasenlagenwert um 360° erhöht wird, und das Umsortierverfahren mit dem nächsten Umsortierschritt fortgesetzt wird und im Falle einer Überschreitung des Alarmschwellenwerts das Umsortieren beendet wird und die bis dahin gebildete umsortierte Phasenlagenreihenfolge als sortierte Phasenlagenreihenfolge weiterverwendet wird.

Das Umsortieren erfolgt bei der obigen Verfahrensweise also anschaulich beschrieben durch ein Umsortieren "nach oben". Das Sortieren der Phasenlagenwerte umfasst bei einer zweiten besonders vorteilhaften Verfahrensvariante vorzugsweise folgende Sortierschritte:

- Vorsortieren der Phasenlagenwerte nach Größe unter Bildung einer vorsortierten Phasenlagenreihenfolge,
- Prüfen, ob die Zeigerwinkeldifferenz zwischen dem Zeigerwinkel eines Messzeigers, der zu dem größten Phasenlagenwert gehört, und dem Zeigerwinkel eines Messzeigers, der zu dem kleinsten Phasenlagenwert gehört, den Alarmschwellenwert über- oder unterschreitet,
- im Falle einer Unterschreitung des Alarmschwellenwerts die Phasenlagenreihenfolge umsortiert wird, indem der größte Phasenlagenwert um 360° reduziert wird, und
- im Falle einer Überschreitung des Alarmschwellenwerts die Phasenlagenreihenfolge unverändert bleibt und die vorsortierte Phasenlagenreihenfolge als sortierte Phasenlagenreihenfolge weiterverwendet wird.

Bei der letztgenannten Verfahrensvariante ist es vorteilhaft, wenn nachfolgend in weiteren Umsortierschritten jeweils geprüft wird, ob die Differenz zwischen dem - gemäß Fortschritt des Umsortierens - jeweils aktuell größten Phasenlagenwert und dem vor dem letzten Umsortierschritt größten Phasenlagenwert den Alarmschwellenwert überschreitet, im Falle einer Unterschreitung des Alarmschwellenwerts die umsortierte Phasenlagenreihenfolge nochmals umsortiert wird, indem der aktuell größte Phasenlagenwert um 360° reduziert wird, und das Umsortierverfahren mit dem nächsten Umsortierschritt fortgesetzt wird und im Falle einer Überschreitung des Alarmschwellenwerts das Umsortieren beendet wird und die bis dahin gebildete umsortierte Phasenlagenreihenfolge als sortierte Phasenlagenreihenfolge weiterverwendet wird.

Das Umsortieren erfolgt bei der zweiten besonders vorteilhaften Verfahrensvariante also anschaulich beschrieben durch ein Umsortieren "nach unten".

Die Phasenlagenwerte werden vorzugsweise nach Größe unter Bildung einer Phasenlagenreihenfolge ausgehend von dem kleinsten Phasenlagenwert in aufsteigender Reihenfolge sortiert.

Die Reihenfolgenrichtung, in der der jeweils nächste benachbarte Phasenlagenwert herangezogen wird, ist vorzugsweise die aufsteigende Richtung.

Auch wird es als vorteilhaft angesehen, wenn anhand von Frequenzwerten oder Frequenzänderungswerten geprüft wird, ob das Energieversorgungsnetz synchron arbeitet und im Falle einer Asynchronität des Energieversorgungsnetzes das Energieversorgungsnetz in Teilnetze aufgeteilt wird, und das oben beschriebene Verfahren für zumindest eines der Teilnetze des Energieversorgungsnetzes durchgeführt wird.

Falls anhand von Frequenzwerten oder Frequenzänderungswerten keine Asynchronität des Energieversorgungsnetzes festgestellt wird, kann das oben beschriebene Verfahren für das gesamte Energieversorgungsnetz oder ein beliebig ausgewähltes Teilnetz durchgeführt werden.

Die Erfindung bezieht sich darüber hinaus auf eine Überwachungseinrichtung zum Überwachen eines elektrischen Energieversorgungsnetzes oder eines Teilnetzes des Energieversorgungsnetzes, wobei die Überwachungseinrichtung Messwerte zumindest zweier Messstellen des Energieversorgungsnetzes oder Teilnetzes heranzieht und gemäß den Merkmalen des Anspruchs 13 ausgebildet ist.

Bezüglich der Vorteile der erfindungsgemäßen Überwachungseinrichtung sei auf die obigen Ausführungen im Zusammenhang mit dem erfindungsgemäßen Verfahren verwiesen.

Die Erfindung wird nachfolgend anhand von Ausführungsbeispielen näher erläutert; dabei zeigen beispielhaft

Figur 1    in einer schematischen Darstellung ein Energieversorgungsnetz, das mit einer Überwachungseinrichtung zur Erkennung einer etwaigen Inselbildung innerhalb des Energieversorgungsnetzes ausgestattet ist,

Figur 2    beispielhaft elektrische Spannungszeiger, die von an das Energieversorgungsnetz gemäß Figur 1 angeschlossenen Messgeräten gemessen werden, in der komplexen Ebene,

Figur 3    ein Ausführungsbeispiel für eine Überwachungseinrichtung, die bei der Anordnung gemäß Figur 1 eingesetzt werden kann,

Figur 4    in Form eines Ablaufdiagramms ein Ausführungsbeispiel für ein Inselerkennungsprogramm, das für die Überwachungseinrichtung gemäß Figur 3 zum Überwachen des Energieversorgungsnetzes gemäß Figur 1 geeignet ist, und

Figur 5    in Form eines Ablaufdiagramms ein weiteres Ausführungsbeispiel für ein Inselerkennungsprogramm, das für die Überwachungseinrichtung gemäß Figur 3 zum Überwachen des Energieversorgungsnetzes gemäß Figur 1 geeignet ist.

In den Figuren werden der Übersicht halber für identische oder vergleichbare Komponenten stets dieselben Bezugszeichen verwendet.

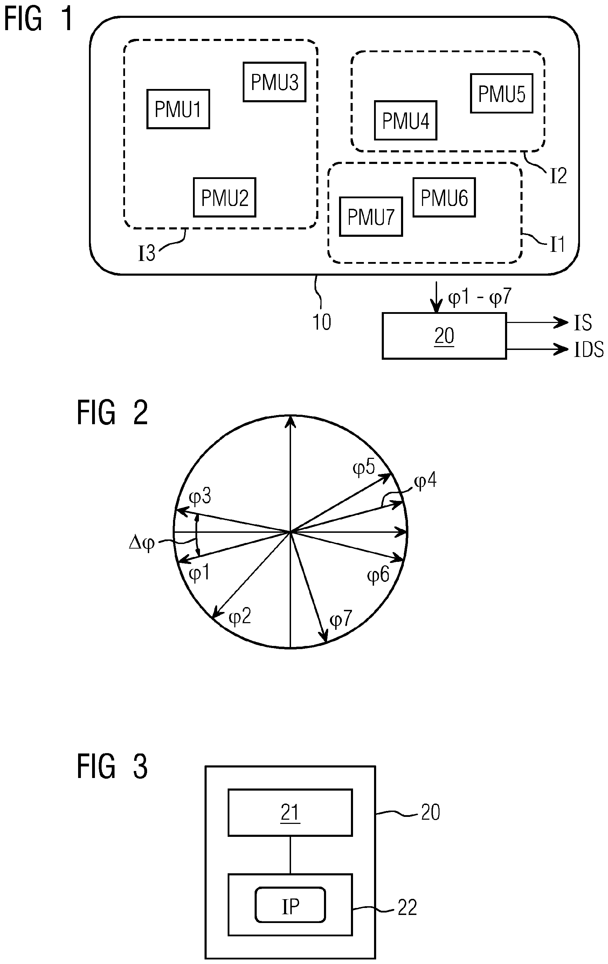

Die Figur 1 zeigt in einer schematischen Darstellung ein Energieversorgungsnetz 10, das mit einer Vielzahl an Messgeräten PMU1 bis PMU7 ausgestattet ist. Bei den Messgeräten PMU1 bis PMU7 handelt es sich vorzugsweise um Zeigermessgeräte, die elektrische Spannungszeiger von Leiterspannungen und/oder Mitsystemspannungen erfassen können. Derartige Messgeräte werden fachsprachlich auch als "Phasor Measurement Units" bezeichnet.

Die Messgeräte PMU1 bis PMU7 sind an eine Überwachungseinrichtung 20 angeschlossen und übertragen an diese ihre Messwerte. Bei den Messwerten handelt es sich, wie weiter unten noch näher im Detail erläutert werden wird, vorzugsweise um Phasenlagenwerte, die mit den Bezugszeichen φ1 bis φ7 gekennzeichnet sind, und/oder um Spannungszeiger von allen drei Phasen, aus denen die zugehörige Mitsystemkomponente ermittelt und deren jeweilige Phasenlage nachfolgend als Phasenlagenwert verwendet wird. Die Verbindung zur Übertragung der Phasenlagenwerte φ1 bis φ7 ist aus Gründen der Übersicht in der Figur 1 nicht näher dargestellt.

Die Figur 2 zeigt in der komplexen Ebene beispielhaft die von den Messgeräten PMU1 bis PMU7 gemäß Figur 1 gemessenen Zeigermesswerte mit den korrespondierenden Phasenlagenwerten φ1 bis φ7.

Die Figur 3 zeigt ein Ausführungsbeispiel für eine Überwachungseinrichtung 20, die bei der Anordnung gemäß Figur 1 zur Überwachung des Energieversorgungsnetzes 10 eingesetzt werden kann.

Die Überwachungseinrichtung 20 umfasst einen Rechner 21 und einen Speicher 22. In dem Speicher 22 ist ein Inselerkennungsprogramm IP abgespeichert, das bei Ausführung durch den Rechner 21 diesen befähigt, das Energieversorgungsnetz 10 gemäß Figur 1 auf eine etwaige Inselbildung hin zu untersuchen.

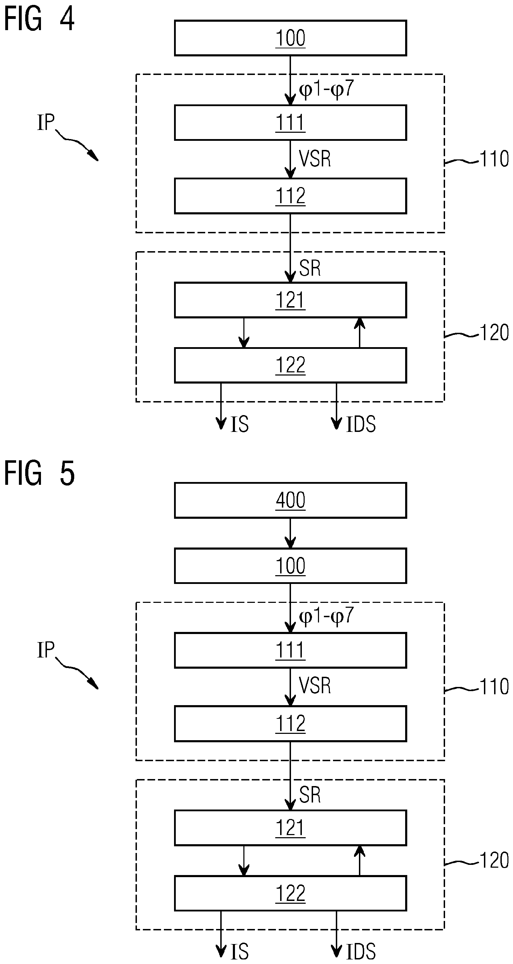

Die Figur 4 zeigt in Form eines Ablaufdiagramms ein Ausführungsbeispiel für ein Inselerkennungsprogramm IP, das von der Überwachungseinrichtung 20 gemäß Figur 3 zur Überwachung des Energieversorgungsnetzes 10 gemäß Figur 1 ausgeführt werden kann.

Das Inselerkennungsprogramm IP gemäß Figur 4 weist einen Erfassungsschritt 100 auf, der zur Erfassung der von den Messgeräten PMU1 bis PMU7 gemäß Figur 1 übermittelten Phasenlagenwerten φ1 bis φ7 dient.

Die im Erfassungsschritt 100 erfassten Phasenlagenwerte φ1 bis φ7 können beispielsweise folgende Werte aufweisen:

PMU1 :        φ1 = -170°
PMU2 :        φ2 = -140°
PMU3 :        φ3 = +170°
PMU4 :        φ4 = +10°
PMU5 :        φ5 = +30°
PMU6 :        φ6 = -29°
PMU7 :        φ7 = -75°

Die im Erfassungsschritt 100 erfassten Phasenlagenwerte φ1 bis φ7 gelangen zu einer Sortierprozedur 110, die einen Vorsortierschritt 111 und eine Umsortierprozedur 112 umfasst.

Im Rahmen des Vorsortierschritts 111 werden die Phasenlagenwerte φ1 bis φ7 nach Größe unter Bildung einer vorsortierten Phasenlagenreihenfolge VSR sortiert. Die im Rahmen des Vorsortierens gebildete vorsortierte Phasenlagenreihenfolge VSR kann beispielsweise wie folgt aussehen:

PMU3 :          $\varphi 3 = +170°$
PMU5 :          $\varphi 5 = +30°$
PMU4 :          $\varphi 4 = +10°$
PMU6 :          $\varphi 6 = -29°$
PMU7 :          $\varphi 7 = -75°$
PMU2 :          $\varphi 2 = -140°$
PMU1 :          $\varphi 1 = -170°$

Die vorsortierte Phasenlagenreihenfolge VSR gelangt zu der Umsortierprozedur 112, in der ein Umsortieren der vorsortierten Phasenlagenreihenfolge unter Bildung einer sortierten Phasenlagenreihenfolge SR erfolgt.

In einem ersten Schritt der Umsortierprozedur 112 wird geprüft, ob die Zeigerwinkeldifferenz zwischen dem Zeigerwinkel des Messzeigers, der zu dem größten Phasenlagenwert (hier $\varphi 3 = +170°$) gehört, und dem Zeigerwinkel des Messzeigers, der zu dem kleinsten Phasenlagenwert (hier $\varphi 1 = -170°$) gehört, einen Alarmschwellenwert AS über- oder unterschreitet.

Nachfolgend wird beispielhaft davon ausgegangen, dass der Alarmschwellenwert AS 60° beträgt.

Im Falle einer Unterschreitung des Alarmschwellenwerts AS - wie es hier der Fall ist, weil die Zeigerwinkeldifferenz $\Delta\varphi$ lediglich 20° beträgt - wird die Phasenlagenreihenfolge umsortiert, indem der kleinste Phasenlagenwert (hier -170°) um 360° erhöht wird. Durch die Erhöhung um 360° ergibt sich nun ein Phasenlagenwert von +190°, der in der Phasenlagenreihenfolge entsprechend einsortiert wird. Es ergibt sich nun folgende Phasenlagenreihenfolge:

PMU1:          $\varphi 1 = +190°$
PMU3 :          $\varphi 3 = +170°$
PMU5 :          $\varphi 5 = +30°$
PMU4 :          $\varphi 4 = +10°$
PMU6 :          $\varphi 6 = -29°$
PMU7 :          $\varphi 7 = -75°$
PMU2 :          $\varphi 2 = -140°$

Durch das Umsortieren des Phasenlagenwerts $\varphi 1$ ist nunmehr der Phasenlagenwert $\varphi 2 = -140°$ der kleinste Phasenlagenwert der Phasenlagenreihenfolge. In weiteren Umsortierschritten wird nun jeweils geprüft, ob die Differenz zwischen dem - gemäß Fortschritt des Umsortierens - jeweils aktuell kleinsten Phasenlagenwert und dem vor dem letzten Umsortierschritt kleinsten Phasenlagenwert den Alarmschwellenwert AS überschreitet oder nicht.

Da - wie erwähnt - nun der Phasenlagenwert $\varphi 2 = -140°$ der kleinste Phasenlagenwert der Phasenlagenreihenfolge ist, wird demgemäß geprüft, ob die Differenz zwischen dem Phasenlagenwert $\varphi 2$ und dem Phasenlagenwert $\varphi 1 = -170°$ (vor dem Erhöhen um 360°) kleiner als der Alarmschwellenwert AS ist.

Da hier gilt:

$$\varphi 2 - \varphi 1 = 30° < AS,$$

wird die Phasenlagenreihenfolge nochmals umsortiert, indem der Phasenlagenwert $\varphi 2$ ebenfalls um 360° erhöht und entsprechend in der Phasenlagenreihenfolge neu einsortiert wird. Es entsteht nun folgende Sortierreihenfolge:

PMU2 :          $\varphi 2 = +220°$
PMU1 :          $\varphi 1 = +190°$
PMU3 :          $\varphi 3 = +170°$
PMU5 :          $\varphi 5 = +30°$
PMU4 :          $\varphi 4 = +10°$
PMU6 :          $\varphi 6 = -29°$
PMU7 :          $\varphi 7 = -75°$

Aufgrund des letzten Umsortierschritts ist nunmehr der Phasenlagenwert $\varphi 7 = -75°$ der kleinste Phasenlagenwert. Da dessen Differenz zu dem zuvor umsortierten Phasenlagenwert $\varphi 2$ (vor dem Erhöhen -140°) 65° beträgt und größer als der Alarmschwellenwert AS ist, wird das Umsortieren bzw. die Umsortierprozedur 112 beendet und folgende sortierte Phasenlagenreihenfolge SR an eine nachgeordnete Analyseprozedur 120 übermittelt:

PMU2 :          $\varphi 2 = +220°$
PMU1 :          $\varphi 1 = +190°$
PMU3 :          $\varphi 3 = +170°$
PMU5 :          $\varphi 5 = +30°$
PMU4 :          $\varphi 4 = +10°$
PMU6 :          $\varphi 6 = -29°$
PMU7 :          $\varphi 7 = -75°$

Im Rahmen der Analyseprozedur 120 werden gemäß der sortierten Phasenlagenreihenfolge SR für jeden auf einen vorgegebenen Startphasenwert folgenden Phasenlagenwert jeweils ein Differenzbildungsschritt 121 und ein Vergleichsschritt 122 durchgeführt.

Nachfolgend wird beispielhaft davon ausgegangen, dass der kleinste Phasenlagenwert der sortierten Phasenlagenreihenfolge SR, hier also der Phasenlagenwert $\varphi 7 = -75°$ den Startphasenwert und damit den ersten Referenzphasenwert bildet.

In dem Differenzbildungsschritt 121 wird zunächst die Phasenlagendifferenz zwischen dem Startphasenwert $\varphi 7$ und dem nächst größten Phasenlagenwert $\varphi 6 = -29°$ ermittelt. Die Phasenlagendifferenz beträgt hier 46°.

In dem nachfolgenden Vergleichsschritt 122 wird geprüft, ob die Phasenlagendifferenz betragsmäßig den Alarmschwellenwert AS über- oder unterschreitet.

Da im vorliegenden Fall die Differenz zwischen den beiden Phasenlagenwerten φ6 und φ7 kleiner als der Alarmschwellenwert AS ist, wird davon ausgegangen, dass die beiden Phasenlagenwerte φ6 und φ7 synchron bzw. gemäß dem in Form des Alarmschwellenwerts AS vorgegebenen Synchronitätskriterium hinreichend synchron sind. Demgemäß wird mit demselben Referenzphasenwert φ7 der nächste Differenzbildungsschritt 121 durchgeführt.

In dem nächsten Differenzbildungsschritt 121 wird nun die Phasenlagendifferenz zwischen dem aktuellen Referenzphasenwert φ7 und dem nachfolgenden Phasenlagenwert φ4 gebildet und mit dem Alarmschwellenwert AS verglichen. Die Differenz beträgt hier 85° und überschreitet den Alarmschwellenwert AS. Aufgrund der Überschreitung des Alarmschwellenwerts AS wird davon ausgegangen, dass der Phasenlagenwert φ4 mit den beiden Phasenlagenwerten φ6 und φ7 nicht mehr synchron (bzw. hinreichend synchron) ist und zu einer eigenen Insel innerhalb des Energieversorgungsnetzes 10 gemäß Figur 1 gehört. Der Phasenlagenwert φ4 wird nun als neuer Referenzphasenwert festgelegt, und es wird mit dem Differenzbildungsschritt 121 für den nächstfolgenden Phasenlagenwert φ5 unter Heranziehung des nun neuen Referenzphasenwerts φ4 weitergearbeitet.

In dem Differenzbildungsschritt 121 wird nachfolgend die Differenz zwischen den Phasenlagenwerten φ5 und φ4 gebildet, und in dem nachfolgenden Vergleichsschritt 122 wird die ermittelte Differenz |φ5-φ4| betragsmäßig mit dem Alarmschwellenwert AS verglichen. Dabei wird festgestellt, dass die Phasenlagendifferenz kleiner als der Alarmschwellenwert ist, φ4 und φ5 synchron (bzw. hinreichend synchron) sind und zu derselben Insel gehören, so dass nachfolgend nun der Phasenlagenwert φ3 untersucht werden kann, wobei es bei dem zuvor herangezogenen Referenzphasenwert φ4 bleibt.

Die Phasenlagendifferenz zwischen dem Phasenlagenwert φ3 und dem Referenzphasenwert φ4 überschreitet den Alarmschwellenwert AS, so dass nun festgestellt wird, dass der Phasenlagenwert φ3 zu einer dritten Insel innerhalb des Energieversorgungsnetzes 10 gehört. Der Phasenlagenwert φ3 wird nun als neuer Referenzphasenwert festgelegt und das Verfahren wird für den nachfolgenden Phasenlagenwert φ1 fortgesetzt.

Da die Phasenlagendifferenz zwischen φ1 und φ3 lediglich 20° beträgt, wird der Phasenlagenwert φ1 zur Insel des Phasenlagenwerts φ3 zugeordnet wird und das Verfahren wird mit dem Referenzphasenwert φ3 fortgesetzt.

Auch bei dem letzten Phasenlagenwert φ2 ist die Phasenlagendifferenz zum aktuellen Referenzphasenwert φ3 klein genug, so dass auch der Phasenlagenwert φ2 der Insel mit den Phasenlagenwerten φ1 und φ3 zugeordnet wird.

Die Analyseprozedur 120 kommt nach Abarbeitung der sortierten Phasenlagenreihenfolge SR somit zu dem Ergebnis, dass ein Inselerkennungssignal IS zu erzeugen ist, das eine Inselbildung innerhalb des Energieversorgungsnetzes 10 anzeigt.

Darüber hinaus erzeugt die Analyseprozedur 120 einen Inseldatensatz IDS, der anzeigt, dass es insgesamt drei Inseln bzw. drei Teilnetze innerhalb des Energieversorgungsnetzes 10 gibt, die jeweils für sich synchron (bzw. hinreichend synchron) arbeiten.

Die Messgeräte PMU1 bis PMU7 werden dabei folgenden Inseln bzw. Teilnetzen zugeordnet (siehe Figur 1):

    Insel I1: PMU7 und PMU6
    Insel I2: PMU4 und PMU5
    Insel I3: PMU3, PMU1 und PMU2.

Die in dem Inseldatensatz IDS festgelegte Zuordnung der Messgeräte PMU1 bis PMU7 zu Inseln ist abhängig von dem Startphasenwert, mit dem die Analyseprozedur 120 begonnen wird. Bei dem obigen Ausführungsbeispiel wurde von dem Phasenlagenwert φ7 als Startphasenwert ausgegangen. Würde alternativ als Startphasenwert der größte Phasenlagenwert φ2 der sortierten Phasenlagenreihenfolge SR ausgewählt werden, so ergäbe sich folgende Zuordnung der Messgeräte PMU1 bis PMU7:

    Insel I1: PMU2, PMU1 und PMU3.
    Insel I2: PMU5, PMU4 und PMU6
    Insel I3: PMU7

Es lässt sich erkennen, dass auch im Falle dieses Startphasenwerts drei Inseln erkannt werden.

Die Auswahl des Startphasenwerts für die Analyseprozedur 120 ist im Übrigen beliebig, es kann statt des größten Phasenlagenwerts oder des kleinsten Phasenlagenwerts auch ein mittlerer Phasenwert ausgewählt werden.

Die Figur 5 zeigt ein weiteres Ausführungsbeispiel für ein Inselerkennungsprogramm IP, das von dem Rechner 21 gemäß Figur 3 zur Erkennung einer Inselbildung innerhalb eines Energieversorgungsnetzes 10 gemäß Figur 1 eingesetzt werden kann.

Im Unterschied zu dem Ausführungsbeispiel gemäß Figur 4 weist das Inselerkennungsprogramm IP gemäß Figur 5 zusätzlich ein Frequenz- und/oder Frequenzänderungsauswertmodul 400 auf, das vor der Ausführung des Erfassungsschritts 100 durchgeführt wird und zunächst eine Vorabprüfung durchführt, ob Frequenzwerte und/oder Frequenzänderungswerte der Messgeräte PMU1 bis PMU7 auf eine Asynchronität bzw. Inselbildung innerhalb des Energieversorgungsnetzes 10 gemäß Figur 1 hindeuten.

Vorteilhaft ist es, wenn die nachfolgende Analyse der Phasenlagenwerte der Messgeräte PMU1 bis PMU7 ausschließlich dann durchgeführt wird, wenn im Rahmen der Ausführung des Frequenz- und/oder Frequenzänderungsauswertmoduls 400 festgestellt wird, dass voraussichtlich eine Inselbildung erfolgt ist. In diesem Falle werden vorzugsweise die von dem Frequenz- und/oder Frequenzänderungsauswertmodul 400 identifizierten synchronen Teilnetze jeweils individuell für sich weiter auf Inseln innerhalb der jeweiligen Teilnetze analysiert, wie dies im Zusammenhang mit der Figur 4 erläutert worden ist.

Alternativ ist es möglich, unabhängig von dem Arbeitsergebnis des Frequenz- und/oder Frequenzänderungsauswertmoduls 400 die Überprüfung der Phasenlagenwerte durchzuführen, wie dies im Zusammenhang mit der Figur 4 oben erläutert worden ist. In diesem Falle kann eine etwaige Inselbildung auch bei sehr geringen Frequenzabweichungen erkannt werden.

Bei den Ausführungsbeispielen gemäß den Figuren 1 bis 5 wurden die Phasenlagenwerte in aufsteigender Reihenfolge sortiert; selbstverständlich ist es auch möglich, die Phasenlagenwerte in entgegengesetzter Reihenfolge zu sortieren. Die übrigen Schritte gemäß den Figuren 4 und 5 können in diesem Falle in analoger Weise durchgeführt werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden.

Bezugszeichenliste

| | |
|---|---|
| 10 | Energieversorgungsnetz |
| 20 | Überwachungseinrichtung |
| 21 | Rechner |
| 22 | Speicher |
| 100 | Erfassungsschritt |
| 110 | Sortierprozedur |
| 111 | Vorsortierschritt |
| 112 | Umsortierprozedur |
| 120 | Analyseprozedur |
| 121 | Differenzbildungsschritt |
| 122 | Vergleichsschritt |
| 400 | Frequenz- und/oder Frequenzänderungsauswertmodul |

| | |
|---|---|
| AS | Alarmschwellenwert |
| IDS | Inseldatensatz |
| I1-I3 | synchrone Inseln |
| IP | Inselerkennungsprogramm |
| PMU1-PMU7 | Messgeräte |
| SR | sortierte Phasenlagenreihenfolge |
| VSR | vorsortierte Phasenlagenreihenfolge |
| φ1-φ7 | Phasenlagenwerte |

**Patentansprüche**

1. Verfahren zum Überwachen eines elektrischen Energieversorgungsnetzes (10) oder eines Teilnetzes des Energieversorgungsnetzes (10), wobei an zumindest zwei Messstellen des Energieversorgungsnetzes (10) oder Teilnetzes erfasste Messwerte ausgewertet werden, wobei

- als Messwerte Phasenlagenwerte ausgewertet oder mit den Messwerten ermittelte Phasenlagenwerte ausgewertet werden,
- anhand der Phasenlagenwerte geprüft wird, ob das Energieversorgungsnetz (10) oder das Teilnetz synchron arbeitet, und
- im Falle einer anhand der Phasenlagenwerte erkannten Asynchronität ein Inselerkennungssignal (IS) erzeugt wird,

**dadurch gekennzeichnet, dass**

- die Phasenlagenwerte unter Bildung einer sortierten Phasenlagenreihenfolge (SR) sortiert werden,
- ausgehend von dem größten oder kleinsten Phasenlagenwert - nachfolgend Startphasenwert genannt - der sortierten Phasenlagenreihenfolge (SR) eine Phasenlagendifferenz zu dem in der Phasenlagenreihenfolge (SR) nachfolgenden, also dem zweitgrößten oder zweitkleinsten, Phasenlagenwert ermittelt wird,
- das Inselerkennungssignal (IS) erzeugt wird, wenn die Phasenlagendifferenz zwischen dem Startphasenwert und dem nachfolgenden Phasenlagenwert betragsmäßig einen vorgegebenen Alarmschwellenwert überschreitet, und
- der Startphasenwert und der nachfolgende Phasenlagenwert als synchron angesehen werden, wenn die Phasenlagendifferenz zwischen dem Startphasenwert und dem nachfolgenden Phasenlagenwert betragsmäßig den vorgegebenen Alarmschwellenwert unterschreitet.

2. Verfahren nach Anspruch 1,
**dadurch gekennzeichnet, dass**
als Messwerte Phasenlagenwerte von Messzeigern, insbesondere Spannungszeigern, ausgewertet werden.

3. Verfahren nach einem der voranstehenden Ansprüche,
**dadurch gekennzeichnet, dass**
als Messwerte Phasenlagenwerte von Leiterspannungszeigern oder Mitsystemspannungszeigern ausgewertet werden.

4. Verfahren nach einem der voranstehenden Ansprüche,
**dadurch gekennzeichnet**, dass
im Falle einer anhand der Phasenlagenwerte erkannten Asynchronität synchron arbeitende Inseln innerhalb des Energieversorgungsnetzes (10) oder des jeweiligen Teilnetzes ermittelt werden.

**5.** Verfahren nach einem der voranstehenden Ansprüche,
**dadurch gekennzeichnet, dass** gemäß der sortierten Phasenlagenreihenfolge (SR) für jeden auf den Startphasenwert folgenden Phasenlagenwert jeweils ein Differenzbildungsschritt und ein Vergleichsschritt durchgeführt wird.

**6.** Verfahren nach Anspruch 5,
**dadurch gekennzeichnet, dass**

- in dem Differenzbildungsschritt die Phasenlagendifferenz zwischen einem Referenzphasenwert, bei dem es sich um den Startphasenwert handelt, sofern er nicht in einem vorherigen Vergleichsschritt durch einen anderen Referenzphasenwert ersetzt worden ist, und dem jeweils folgenden Phasenlagenwert ermittelt wird, und
- in dem Vergleichsschritt

- die Phasenlagendifferenz mit dem Alarmschwellenwert verglichen wird,
- die bei dem Vergleich betrachteten Phasenlagenwerte als synchron angesehen werden und mit dem Differenzbildungsschritt für den nachfolgenden Phasenlagenwert in der Phasenlagenreihenfolge (SR) und demselben Referenzphasenwert fortgefahren wird, wenn die Phasenlagendifferenz betragsmäßig den Alarmschwellenwert unterschreitet, und
- der bei dem vorherigen Differenzbildungsschritt als folgender Phasenlagenwert herangezogene Phasenlagenwert einer neuen Insel zugeordnet und als neuer Referenzphasenwert festgelegt wird und mit dem Differenzbildungsschritt für den nachfolgenden Phasenlagenwert in der Phasenlagenreihenfolge (SR) und dem neu festgesetzten Referenzphasenwert fortgefahren wird, wenn die Phasenlagendifferenz betragsmäßig den Alarmschwellenwert überschreitet.

**7.** Verfahren nach einem der voranstehenden Ansprüche,
**dadurch gekennzeichnet, dass**
das Sortieren der Phasenlagenwerte folgende Sortierschritte umfasst:

- Vorsortieren der Phasenlagenwerte nach Größe unter Bildung einer vorsortierten Phasenlagenreihenfolge (VSR),
- Prüfen, ob die Zeigerwinkeldifferenz zwischen dem Zeigerwinkel des Messzeigers, der zu dem größten Phasenlagenwert gehört, und dem Zeigerwinkel des Messzeigers, der zu dem kleinsten Phasenlagenwert gehört, den Alarmschwellenwert über- oder unterschreitet,
- im Falle einer Unterschreitung des Alarmschwellenwerts die Phasenlagenreihenfolge umsortiert wird, indem der kleinste Phasenlagenwert um 360° erhöht wird, und
- im Falle einer Überschreitung des Alarmschwellenwerts die Phasenlagenreihenfolge unverändert bleibt und die vorsortierte Phasenlagenreihenfolge (VSR) als sortierte Phasenlagenreihenfolge (SR) weiterverwendet wird.

**8.** Verfahren nach Anspruch 7,
**dadurch gekennzeichnet, dass**

- im Falle eines erfolgten Umsortierens nachfolgend in weiteren Umsortierschritten jeweils geprüft wird, ob die Differenz zwischen dem - gemäß Fortschritt des Umsortierens - jeweils aktuell kleinsten Phasenlagenwert und dem vor dem letzten Umsortierschritt kleinsten Phasenlagenwert den Alarmschwellenwert überschreitet,
- im Falle einer Unterschreitung des Alarmschwellenwerts die umsortierte Phasenlagenreihenfolge nochmals umsortiert wird, indem der aktuell kleinste Phasenlagenwert um 360° erhöht wird, und das Umsortierverfahren mit dem nächsten Umsortierschritt fortgesetzt wird und
- im Falle einer Überschreitung des Alarmschwellenwerts das Umsortieren beendet wird und die bis dahin gebildete umsortierte Phasenlagenreihenfolge als sortierte Phasenlagenreihenfolge (SR) weiterverwendet wird.

**9.** Verfahren nach einem der voranstehenden Ansprüche 1 bis 6,
**dadurch gekennzeichnet, dass**
das Sortieren der Phasenlagenwerte folgende Sortierschritte umfasst:

- Vorsortieren der Phasenlagenwerte nach Größe unter Bildung einer vorsortierten Phasenlagenreihenfolge (VSR),
- Prüfen, ob die Zeigerwinkeldifferenz zwischen dem Zeigerwinkel eines Messzeigers, der zu dem größten Phasenlagenwert gehört, und dem Zeigerwinkel eines Messzeigers, der zu dem kleinsten Phasenlagenwert gehört, den Alarmschwellenwert über- oder unterschreitet,
- im Falle einer Unterschreitung des Alarmschwellenwerts die Phasenlagenreihenfolge umsortiert wird, indem der größte Phasenlagenwert um 360° reduziert wird, und
- im Falle einer Überschreitung des Alarmschwellenwerts die Phasenlagenreihenfolge unverändert bleibt und die vorsortierte Phasenlagenreihenfolge (VSR) als sortierte Phasenlagenreihenfolge (SR) weiterverwendet wird.

**10.** Verfahren nach Anspruch 9,
**dadurch gekennzeichnet, dass**

- im Falle eines erfolgten Umsortierens nachfolgend in weiteren Umsortierschritten jeweils geprüft wird, ob die Differenz zwischen dem - gemäß Fortschritt des Umsortierens - jeweils aktuell größten Phasenlagenwert und dem vor dem letzten Umsortierschritt größten Phasenlagenwert den Alarmschwellenwert überschreitet,
- im Falle einer Unterschreitung des Alarmschwellenwerts die umsortierte Phasenlagenreihenfolge nochmals umsortiert wird, indem der aktuell größte Phasenlagenwert um 360° reduziert wird, und das Umsortierverfahren mit dem nächsten Umsortierschritt fortgesetzt wird und
- im Falle einer Überschreitung des Alarmschwellenwerts das Umsortieren beendet wird und die bis dahin gebildete umsortierte Phasenlagenreihenfolge als sortierte Phasenlagenreihenfolge (SR) weiterverwendet wird.

**11.** Verfahren nach einem der voranstehenden Ansprüche,
**dadurch gekennzeichnet, dass**

- die Phasenlagenwerte nach Größe unter Bildung einer Phasenlagenreihenfolge (SR) ausgehend von dem kleinsten Phasenlagenwert in aufsteigender Reihenfolge sortiert werden und/oder
- die Reihenfolgenrichtung, in der der jeweils nächste benachbarte Phasenlagenwert herangezogen wird, die aufsteigende Richtung ist.

**12.** Verfahren nach einem der voranstehenden Ansprüche,
**dadurch gekennzeichnet, dass**

- anhand von Frequenzwerten oder Frequenzänderungswerten geprüft wird, ob das Energieversorgungsnetz (10) synchron arbeitet und im Falle einer Asynchronität des Energieversorgungsnetzes (10) das Energieversorgungsnetz in Teilnetze aufgeteilt wird, und
- das Verfahren nach einem der voranstehenden Ansprüche für zumindest eines der Teilnetze des Energieversorgungsnetzes (10) durchgeführt wird.

**13.** Überwachungseinrichtung zum Überwachen eines elektrischen Energieversorgungsnetzes (10) oder eines Teilnetzes des Energieversorgungsnetzes (10), wobei die Überwachungseinrichtung Messwerte zumindest zweier Messstellen des Energieversorgungsnetzes (10) oder Teilnetzes heranzieht, wobei die Überwachungseinrichtung derart ausgestaltet ist, dass sie als Messwerte Phasenlagenwerte auswertet oder mit den Messwerten Phasenlagenwerte selbst ermittelt, anhand der Phasenlagenwerte prüft, ob das Energieversorgungsnetz (10) oder das Teilnetz synchron arbeitet, und im Falle einer anhand der Phasenlagenwerte erkannten Asynchronität ein Inselerkennungssignal (IS) erzeugt,
**dadurch gekennzeichnet, dass**
die Überwachungseinrichtung derart ausgestaltet ist, dass

- die Phasenlagenwerte unter Bildung einer sortierten Phasenlagenreihenfolge (SR) sortiert werden,
- ausgehend von dem größten oder kleinsten Phasenlagenwert - nachfolgend Startphasenwert genannt - der sortierten Phasenlagenreihenfolge (SR) eine Phasenlagendifferenz zu dem in der Phasenlagenreihenfolge (SR) nachfolgenden, also dem zweitgrößten oder zweitkleinsten, Phasenlagenwert ermittelt wird,
- das Inselerkennungssignal (IS) erzeugt wird, wenn die Phasenlagendifferenz zwischen dem Startphasenwert und dem nachfolgenden Phasenlagenwert betragsmäßig einen vorgegebenen Alarmschwellenwert überschreitet, und
- der Startphasenwert und der nachfolgende Phasenlagenwert als synchron angesehen werden, wenn die Phasenlagendifferenz zwischen dem Startphasenwert und dem nachfolgenden Phasenlagenwert betragsmäßig den vorgegebenen Alarmschwellenwert unterschreitet.

**Claims**

**1.** Method for monitoring an electrical energy supply network (10) or a subnetwork of the energy supply network (10), wherein measurement values detected at at least two measurement points of the energy supply network (10) or subnetwork are evaluated, wherein

- phase angle values are evaluated as measurement values or phase angle values determined using the measurement values are evaluated,
- a check is carried out based on the phase angle values to determine whether the energy supply network (10) or the subnetwork is operating synchronously, and,
- in the event of an asynchronism identified based on the phase angle values, an island identification signal (IS) is generated,
**characterized in that**
- the phase angle values are sorted so as to form a sorted phase angle order (SR),
- proceeding from the largest or smallest phase angle value - subsequently referred to as starting phase value - of the sorted phase angle order (SR), a phase angle difference from the subsequent phase angle value in the phase angle order (SR), that is to say the second-largest or second-smallest phase angle value, is determined,

- the island identification signal (IS) is generated when the phase angle difference between the starting phase value and the subsequent phase angle value exceeds a prescribed alarm threshold value in terms of magnitude, and

- the starting phase value and the subsequent phase angle value are considered to be synchronous when the phase angle difference between the starting phase value and the subsequent phase angle value undershoots the prescribed alarm threshold value in terms of magnitude.

2. Method according to Claim 1,
   **characterized in that**
   phase angle values of measurement phasors, in particular voltage phasors, are evaluated as measurement values.

3. Method according to either of the preceding claims,
   **characterized in that**
   phase angle values of conductor voltage phasors or positive phase-sequence system voltage phasors are evaluated as measurement values.

4. Method according to one of the preceding claims,
   **characterized in that**,
   in the event of an asynchronism identified based on the phase angle values, synchronously operating islands within the energy supply network (10) or the respective subnetwork are determined.

5. Method according to one of the preceding claims,
   **characterized in that**
   a difference formation step and a comparison step are carried out in each case for each phase angle value following the starting phase value according to the sorted phase angle order (SR) .

6. Method according to Claim 5,
   **characterized in that**,

   - in the difference formation step, the phase angle difference between a reference phase value, which is the starting phase value provided it has not been replaced by another reference phase value in a preceding comparison step, and the respectively following phase angle value is determined, and,
   - in the comparison step,

      - the phase angle difference is compared with the alarm threshold value,

   - the phase angle values observed during the comparison are considered to be synchronous and the method proceeds with the difference formation step for the subsequent phase angle value in the phase angle order (SR) and the same reference phase value when the phase angle difference undershoots the alarm threshold value in terms of magnitude, and

   - the phase angle value used as the following phase angle value in the preceding difference formation step is assigned to a new island and is stipulated as a new reference phase value and the method proceeds with the difference formation step for the subsequent phase angle value in the phase angle order (SR) and the newly set reference phase value when the phase angle difference exceeds the alarm threshold value in terms of magnitude.

7. Method according to one of the preceding claims,
   **characterized in that**
   the sorting of the phase angle values comprises the following sorting steps:

      - presorting the phase angle values according to size so as to form a presorted phase angle order (VSR),
      - checking to determine whether the phasor angle difference between the phasor angle of the measurement phasor belonging to the largest phase angle value and the phasor angle of the measurement phasor belonging to the smallest phase angle value exceeds or undershoots the alarm threshold value,
      - in the event of the alarm threshold value being undershot, the phase angle order is resorted by virtue of the smallest phase angle value being increased by 360°, and
      - in the event of the alarm threshold value being exceeded, the phase angle order remains unchanged and the presorted phase angle order (VSR) continues to be used as the sorted phase angle order (SR).

8. Method according to Claim 7,
   **characterized in that**,

      - in the event of successful resorting, a check is subsequently carried out in each further resorting step to determine whether the difference between the - according to the advancement of the resorting - respectively currently smallest phase angle value and the smallest phase angle value before the last resorting step exceeds the alarm threshold value,
      - in the event of the alarm threshold value being undershot, the resorted phase angle order is resorted again by virtue of the currently smallest phase angle value being increased by 360°, and the resorting method is continued with the next resorting step and

- in the event of the alarm threshold value being exceeded, the resorting is ended and the resorted phase angle order formed until this point continues to be used as the sorted phase angle order (SR).

9. Method according to one of preceding Claims 1 to 6, **characterized in that**
the sorting of the phase angle values comprises the following sorting steps:

- presorting the phase angle values according to size so as to form a presorted phase angle order (VSR),
- checking to determine whether the phasor angle difference between the phasor angle of a measurement phasor belonging to the largest phase angle value and the phasor angle of a measurement phasor belonging to the smallest phase angle value exceeds or undershoots the alarm threshold value,
- in the event of the alarm threshold value being undershot, the phase angle order is resorted by virtue of the largest phase angle value being reduced by 360°, and
- in the event of the alarm threshold value being exceeded, the phase angle order remains unchanged and the presorted phase angle order (VSR) continues to be used as the sorted phase angle order (SR).

10. Method according to Claim 9, **characterized in that**,

- in the event of successful resorting, a check is subsequently carried out in each further resorting step to determine whether the difference between the - according to the advancement of the resorting - respectively currently largest phase angle value and the largest phase angle value before the last resorting step exceeds the alarm threshold value,
- in the event of the alarm threshold value being undershot, the resorted phase angle order is resorted again by virtue of the currently largest phase angle value being reduced by 360° and the resorting method is continued with the next resorting step and
- in the event of the alarm threshold value being exceeded, the resorting is ended and the resorted phase angle order formed until this point continues to be used as the sorted phase angle order (SR).

11. Method according to one of the preceding claims, **characterized in that**

- the phase angle values are sorted according to size so as to form a phase angle order (SR) proceeding from the smallest phase angle value in ascending order and/or
- the order direction in which the respectively next adjacent phase angle value is used is the ascending direction.

12. Method according to one of the preceding claims, **characterized in that**

- a check is carried out based on frequency values or frequency change values to determine whether the energy supply network (10) is operating synchronously and, in the event of an asynchronism of the energy supply network (10), the energy supply network is divided into subnetworks, and
- the method according to one of the preceding claims is carried out for at least one of the subnetworks of the energy supply network (10).

13. Monitoring device for monitoring an electrical energy supply network (10) or a subnetwork of the energy supply network (10), wherein the monitoring device uses measurement values of at least two measurement points of the energy supply network (10) or subnetwork, wherein
the monitoring device is designed in such a way that it evaluates phase angle values as measurement values or determines phase angle values using the measurement values itself, checks based on the phase angle values whether the energy supply network (10) or the subnetwork is operating synchronously, and, in the event of an asynchronism identified based on the phase angle values, generates an island identification signal (IS),
**characterized in that**
the monitoring device is designed in such a way that

- the phase angle values are sorted so as to form a sorted phase angle order (SR),
- proceeding from the largest or smallest phase angle value - subsequently referred to as starting phase value - of the sorted phase angle order (SR), a phase angle difference from the subsequent phase angle value in the phase angle order (SR), that is to say the second-largest or second-smallest phase angle value, is determined,
- the island identification signal (IS) is generated when the phase angle difference between the starting phase value and the subsequent phase angle value exceeds a prescribed alarm threshold value in terms of magnitude, and

- the starting phase value and the subsequent phase angle value are considered to be synchronous when the phase angle difference between the starting phase value and the subsequent phase angle value undershoots the prescribed alarm threshold value in terms of magnitude.

**Revendications**

1. Procédé de contrôle d'un réseau (10) d'alimentation en énergie électrique ou d'un sous-réseau du réseau (10) d'alimentation en énergie, dans lequel on exploite des valeurs de mesure relevées en au moins deux points de mesure du réseau (10) d'alimentation en énergie ou du sous-réseau, dans lequel

   - on exploite, comme valeurs de mesure, des valeurs de position en phase ou on exploite des valeurs de position en phase déterminées par les valeurs de mesure,
   - à l'aide des valeurs de position en phase, on contrôle si le réseau (10) d'alimentation en énergie ou le sous-réseau fonctionne de manière synchronisé, et
   - dans le cas d'un défaut de synchronisme, détecté à l'aide des valeurs de position en phase, on produit un signal (IS) de détection d'îlot, **caractérisé en ce que**
   - on trie les valeurs de position en phase en formant une suite (SR) de positions en phase triée,
   - à partir de la valeur de position en phase la plus grande ou la plus petite - dénommée dans ce qui suit valeur de phase initiale - de la suite (SR) de positions en phase triée, on détermine une différence de position de phase par rapport à la valeur de position de phase suivante dans la suite (SR) de positions de phase, donc l'avant plus grande ou l'avant plus petite,
   - on produit le signal (IS) de détection d'îlot, si la différence de position de phase entre la valeur de phase initiale et la valeur de position de phase suivante dépasse en valeur absolue une valeur de seuil d'alerte donnée à l'avance, et
   - on considère comme synchrone la valeur de phase initiale et la valeur de position de phase suivante, si la différence de position de phase entre la valeur de phase initiale et la valeur de position de phase suivante est inférieure en valeur absolue à la valeur de seuil d'alerte donnée à l'avance.

2. Procédé suivant la revendication 1, **caractérisé en ce que** l'on exploite, comme valeurs de mesure, des valeurs de position de phase de vecteurs de mesure, notamment de vecteurs de tension.

3. Procédé suivant l'une des revendications précédentes, **caractérisé en ce que** l'on exploite, comme valeurs de mesure, des valeurs de position de phase de vecteurs de tension composée ou des vecteurs de tension directe.

4. Procédé suivant l'une des revendications précédentes, **caractérisé en ce que**, dans le cas d'un défaut de synchronisme détecté à l'aide des valeurs de position de phase, on détermine des îlots fonctionnant de manière synchrone dans le réseau (10) d'alimentation en énergie ou dans le sous-réseau respectif.

5. Procédé suivant l'une des revendications précédentes, **caractérisé en ce que** suivant la suite (SR) de positions en phase triée, on effectue, pour chaque valeur de position de phase suivant la valeur de phase initiale, respectivement, un stade de formation de différence et un stade de comparaison.

6. Procédé suivant la revendication 5, **caractérisé en ce que**

   - dans le stade de formation d'une différence, on détermine la différence de position de phase entre une valeur de phase de référence, qui est la valeur de phase initiale dans la mesure où elle n'a pas été remplacée dans un stade de comparaison précédent par une autre valeur de phase de référence, et la valeur de position de phase suivante, et
   - dans le stade comparaison

      - on compare la différence de position de phase à la valeur de seuil d'alerte,
      - on considère comme synchrones les valeurs de position de phase envisagées dans la comparaison et on poursuit par le stade de formation d'une différence pour la valeur de position de phase suivante dans la suite (SR) de positions de phase et la même valeur de phase de référence, si la différence de position de phase est inférieure en valeur absolue à la valeur de seuil d'alerte, et
      - on associe à un îlot nouveau la valeur de position de phase mise à profit comme valeur de position de phase suivante lors du stade précédent de formation d'une différence et on la fixe comme nouvelle valeur de phase de référence et, par le stade de formation d'une différence, on poursuit pour la valeur de position de phase suivante dans la suite (SR) de positions de phase et la valeur de phase de référence fixée nouvellement, si la différence de position de phase dépasse en valeur absolue la valeur de seuil d'alerte.

7.  Procédé suivant l'une des revendications précédentes,
    **caractérisé en ce que**
    le tri des valeurs de position de phase comprend des stades de tri suivants :

    - tri préalable des valeurs de position de phase suivant la dimension avec formation d'une suite (VSR) de positions de phase prétriée,
    - contrôle du point de savoir si la différence d'angle vectoriel entre l'angle vectoriel du vecteur de mesure, qui appartient à la valeur de position de phase la plus grande, et l'angle vectoriel du vecteur de mesure, qui appartient à la valeur de position de phase la plus petite, est supérieure ou inférieure à la valeur de seuil d'alerte,
    - dans le cas où elle est inférieure à la valeur de seuil d'alerte, on retrie la suite de positions de phase en augmentant la valeur de position de phase la plus petite de 360°, et
    - dans le cas où elle est supérieure à la valeur de seuil d'alerte, on laisse inchangée la suite de positions de phase et l'on continue à utiliser la suite (VSR) de positions de phase prétriée comme suite (SR) de positions de phase triée.

8.  Procédé suivant la revendication 7,
    **caractérisé en ce que**

    - dans le cas d'un retri effectué, suivant d'autres stades de retri, on contrôle chaque fois si la différence entre la valeur de position de phase la plus petite en cours, respectivement, - selon la progression du retri - et la valeur de position de phase la plus petite avant le dernier stade de retri, dépasse la valeur de seuil d'alerte,
    - dans le cas où elle est inférieure à la valeur de seuil d'alerte, on retrie encore une fois la suite de positions de phase retriée, en augmentant la valeur de position de phase la plus petite en cours de 360° et en poursuivant le procédé de retri par le stade de retri immédiatement suivant et
    - dans le cas d'un dépassement de la valeur de seuil d'alerte, on met fin au retri et on continue à utiliser, comme suite (SR) de positions de phase triée, la suite de positions de phase retriée formée jusqu'ici.

9.  Procédé suivant l'une des revendications 1 à 6 précédentes,
    **caractérisé en ce que**
    le tri des valeurs de position de phase comprend des stades de tri suivant :

    - tri préalable des valeurs de position de phase suivant la grandeur avec formation d'une suite (VSR) de positions de phase prétriée,
    - contrôle du point de savoir si la différence d'angle vectoriel entre l'angle vectoriel du vecteur de mesure, qui appartient à la valeur de position de phase la plus grande, et l'angle vectoriel du vecteur de mesure, qui appartient à la valeur de position de phase la plus petite, est supérieure ou inférieure à la valeur de seuil d'alerte,
    - dans le cas où elle est inférieure à la valeur de seuil d'alerte, on retrie la suite de positions de phase en diminuant la valeur de position de phase la plus petite de 360°, et
    - dans le cas où elle est supérieure à la valeur de seuil d'alerte, on laisse inchangée la suite de positions de phase et l'on continue à utiliser la suite (VSR) de positions de phase prétriée comme suite (SR) de positions de phase triée.

10. Procédé suivant la revendication 9,
    **caractérisé en ce que**

    - dans le cas d'un retri effectué suivant d'autres stades de retri, on contrôle chaque fois si la différence entre la valeur de position de phase la plus grande en cours, respectivement, - selon la progression du retri - et la valeur de position de phase la plus grande avant le dernier stade de retri, dépasse la valeur de seuil d'alerte,
    - dans le cas où elle est inférieure à la valeur de seuil d'alerte, on retrie encore une fois la suite de positions de phase retriée, en augmentant la valeur de position de phase la plus grande en cours de 360° et en poursuivant le procédé de retri par le stade de retri immédiatement suivant et
    - dans le cas où elle est supérieure à la valeur de seuil d'alerte on met fin au retri et on continue à utiliser, comme suite (SR) de positions de phase triée, la suite de positions de phase retriée formée jusqu'ici.

11. Procédé suivant l'une des revendications précédentes,
    **caractérisé en ce que**

    - l'on trie en une suite croissante, à partir de la valeur de position de phase la plus petite, les valeurs de position de phase suivant la dimension, en formant une suite (SR) de positions de phase et/ou
    - le sens de la suite, dans lequel on tire parti de la valeur de position de phase immédiatement voisine, respectivement, est le sens croissant.

**12.** Procédé suivant l'une des revendications précédentes,

**caractérisé en ce que**

- on contrôle, à l'aide de valeurs de fréquence ou de valeurs de variation de fréquence, si le réseau (10) d'alimentation en énergie fonctionne de manière synchrone et, dans le cas d'un défaut de synchronisme du réseau (10) d'alimentation en énergie, on subdivise le réseau d'alimentation en énergie en des sous-réseaux, et

- on effectue le procédé suivant l'une des revendications précédentes pour au moins l'un des sous-réseaux du réseau (10) d'alimentation en énergie.

**13.** Dispositif de contrôle pour contrôler un réseau (10) d'alimentation en énergie électrique ou un sous-réseau du réseau (10) d'alimentation en énergie électrique, le dispositif de contrôle tirant parti de valeurs de mesure en au moins deux points de mesure du réseau (10) d'alimentation en énergie ou du sous-réseau, dans lequel

le dispositif de contrôle est conformé de manière à exploiter, comme valeurs de mesure, des valeurs de position de phase ou de manière à déterminer soi-même des valeurs de position de phase par les valeurs de mesure, à contrôler, à l'aide des valeurs de position de phase, si le réseau (10) d'alimentation en énergie ou le sous-réseau fonctionne de manière synchrone et, dans le cas d'un défaut de synchronisme détecté à l'aide des valeurs de position de phase, à produire un signal (IS) de détection d'îlot,

**caractérisé en ce que**

le dispositif de contrôle est conformé de manière

- à trier les valeurs de position de phase avec formation d'une suite (SR) de positions de phase triée,

- à partir de la valeur de position de phase la plus grande ou la plus petite - dénommée dans ce qui suit valeur de phase initiale - de la suite (SR) de positions de phase triée, à déterminer une différence de position de phase par rapport à la valeur de position de phase suivante, donc la plus grande ou la plus petite suivante dans la suite (SR) de positions de phase,

- à produire le signal (IS) de détection d'îlot, si la différence de position de phase entre la valeur de phase initiale et la valeur de position de phase suivante dépasse en valeur absolue une valeur de seuil d'alerte donnée à l'avance, et

- à considérer comme synchrone, la valeur de phase initiale et la valeur de position de phase suivante, si la différence de position de phase, entre la valeur de phase et la valeur de position de phase suivante, est inférieure en valeur absolue à la valeur de seuil d'alerte donnée à l'avance.

FIG 1

PMU3

PMU1

PMU5

PMU4

PMU2

PMU6

PMU7

I2

I3

I1

10

φ1 - φ7

20

IS

IDS

FIG 2

φ5

φ4

φ3

Δφ

φ1

φ6

φ2

φ7

FIG 3

21

20

IP

22

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9804209 B2

- EP 2806280 A1

**In der Beschreibung aufgeführte Nicht-Patentliteratur**

- **T. OHNO et al.** *Islanding protection system based on synchronized phasor measurements and its operational experiences*